# DEMANDE DE BREVET EUROPEEN

(11) **EP 4 421 809 A1**
(43) Date de publication de la demande: **28.08.2024**
(21) Numéro de dépôt: 24158011.7
(22) Date de dépôt: 16.02.2024
(51) Int. Cl.: G11C 16/04, G11C 16/10, H10B 41/10, H10B 41/70, H10B 41/20, G11C 16/26

(54) **CELLULE MÉMOIRE**

(30) Priorité: 27.02.2023 FR 2301765
(71) Demandeur: STMicroelectronics International N.V., 1228 Plan-les-Ouates, Geneva (CH)
(72) Inventeur: CALENZO, Patrick, 13124 PEYPIN (FR)
(74) Mandataire: Cabinet Beaumont

(57) **Abrégé**

La présente description concerne un procédé d'utilisation d'une cellule mémoire (10) reprogrammable, la cellule comprenant trois régions semiconductrices, la deuxième région comprenant des deuxièmes parties supérieures (22a, 22b), les deuxième parties supérieures formant un transistor (44) avec des première (34) et deuxième (38) couche, une première partie (24a) supérieure de la première région (24) située en regard de la deuxième couche conductrice(38) étant dopée d'un type de conductivité opposé à celui d'une troisième partie (20a) supérieure de la troisième partie (20) située en regard de la deuxième couche, le procédé comprenant la programmation de valeurs :
- par l'application d'un champ électrique compris entre 5 MV/cm et 10 MV/cm entre la première région (24) et la deuxième couche ; et
- par l'application d'un champ électrique compris entre 5 MV/cm et 10 MV/cm entre la troisième région (20) et la deuxième couche.

## Description

### Domaine technique

La présente description concerne de façon générale les dispositifs électroniques et plus précisément les mémoires comprenant des cellules mémoire reprogrammables.

### Technique antérieure

Un grand nombre de dispositifs électroniques comprennent des mémoires, et en particulier des mémoires reprogrammables. Cependant, certaines technologies de cellules mémoire ne sont pas adaptées à tous les circuits.

De plus, l'adaptation de cellules mémoire à des technologies différentes engendre souvent le besoin d'étapes de masquage supplémentaires très couteuses.

### Résumé de l'invention

Un mode de réalisation pallie tout ou partie des inconvénients des cellules mémoire connues.

Un mode de réalisation prévoit un procédé d'utilisation d'une cellule mémoire reprogrammable, la cellule comprenant des première, deuxième et troisième régions semiconductrices délimitées latéralement par des murs conducteurs isolés, la cellule mémoire comprenant en outre une première couche isolante recouvrant les première, deuxième et troisième régions et une deuxième couche conductrice située en regard d'une partie de chacune de première, deuxième et troisième régions, une première partie supérieure de la première région située en regard de la deuxième couche étant dopée d'un premier type de conductivité, la deuxième région comprenant des deuxièmes parties supérieures, les deuxième parties supérieures formant un transistor avec les première et deuxième couches, une troisième partie supérieure de la troisième région située en regard de la deuxième couche étant dopée d'un deuxième type de conductivité, le procédé comprenant :
- la programmation d'une première valeur dans la cellule mémoire par l'application d'un champ électrique compris entre 5 MV/cm et 10 MV/cm entre la première région et la deuxième couche ; et
- la programmation d'une deuxième valeur dans la cellule mémoire par l'application d'un champ électrique compris entre 5 MV/cm et 10 MV/cm entre la troisième région et la deuxième couche.

Un autre mode de réalisation prévoit une cellule mémoire reprogrammable, la cellule comprenant des première, deuxième et troisième régions semiconductrices délimitées latéralement par des murs conducteurs isolés, la cellule mémoire comprenant en outre une première couche isolante recouvrant les première, deuxième et troisième régions et une deuxième couche conductrice située en regard d'une partie de chacune de première, deuxième et troisième régions, une première partie supérieure de la première région située en regard de la deuxième couche étant dopée d'un premier type de conductivité, la deuxième région comprenant des deuxièmes parties supérieures, les deuxième parties supérieures formant un transistor avec les première et deuxième couches, une troisième partie supérieure de la troisième région située en regard de la deuxième couche étant dopée d'un deuxième type de conductivité, la cellule étant configurée pour que :
- une première valeur soit programmée dans la cellule lorsqu'un champ électrique compris entre 5 MV/cm et 10 MV/cm est appliqué entre la première région et la deuxième couche ;
- une deuxième valeur soit programmée dans la cellule lorsqu'un champ électrique compris entre 5 MV/cm et 10 MV/cm est appliqué entre la troisième région et la deuxième couche.

Selon un mode de réalisation, le transistor est un transistor MOSFET.

Selon un mode de réalisation, le premier type de conductivité est le type P et le deuxième type de conductivité est le type N.

Selon un mode de réalisation, la programmation de la première valeur de la cellule comprend les étapes suivantes :
rendre flottante les deuxième et troisième régions ;
appliquer une tension positive à la première région de manière à générer un champ électrique compris entre 5 MV/cm et 10 MV/cm.

Selon un mode de réalisation, la programmation à la deuxième valeur de la cellule comprend les étapes suivantes :
rendre flottante les première et deuxièmes régions ;
appliquer une tension négative à la troisième région de manière à générer un champ électrique compris entre 5 MV/cm et 10 MV/cm.

Selon un mode de réalisation, le champ électrique généré est sensiblement égal à 7 MV/cm.

Selon un mode de réalisation, la première région et les première et deuxième couches forment un premier condensateur ayant un rapport de couplage capacitif compris entre 0,2 et 0,5, et la troisième région et les première et deuxième couches forment un deuxième condensateur ayant un rapport de couplage capacitif compris entre 0,2 et 0,5.

Selon un mode de réalisation, les première, deuxième et troisième régions s'étendent à partir d'une région semiconductrice dopée du deuxième type de conductivité isolée du substrat dopé du deuxième type de conductivité par un caisson enterré dopé du premier type de conductivité.

Selon un mode de réalisation, la troisième couche est en silicium polycristallin.

Selon un mode de réalisation, chaque mur comprend une gaine isolante et un coeur en silicium polycristallin.

Selon un mode de réalisation, la cellule est configurée pour qu'une étape de lecture de la cellule mémoire comprenne l'application d'une tension positive entre les bornes de conduction du transistor et la mesure du courant traversant le transistor, les première et troisième régions recevant une tension nulle.

Selon un mode de réalisation, le procédé comprend :
- la gravure de cavités aux emplacements des murs conducteurs isolés ;
- la formation d'une couche isolante sur les parois et le fond des cavités ;
- le remplissage des cavités avec un matériau conducteur ;
- le dépôt de la première couche ;
- le dopage des première, deuxième et troisième régions ; et
- la formation de la deuxième couche.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente une vue en perspective d'un mode de réalisation d'une cellule mémoire ;
la figure 1B représente une vue en coupe du mode de réalisation de la figure 1A ;
la figure 1C représente une vue en coupe du mode de réalisation de la figure 1A ;
la figure 2A illustre une première étape d'un mode de mise en oeuvre d'un procédé de programmation de la cellule des figures 1A et 1B ;
la figure 2B illustre une deuxième étape d'un mode de mise en oeuvre d'un procédé de programmation de la cellule des figures 1A et 1B ;
la figure 2C illustre un mode de mise en oeuvre d'un procédé de lecture de la cellule des figures 1A et 1B ; et
la figure 3 illustre les différents états de la cellule mémoire des figures 1A à 1C.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

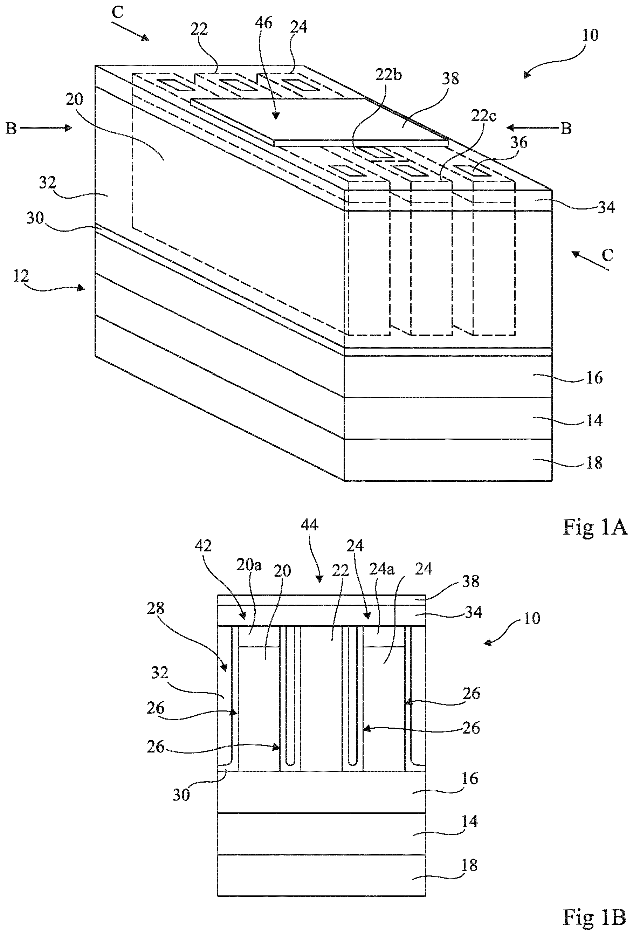

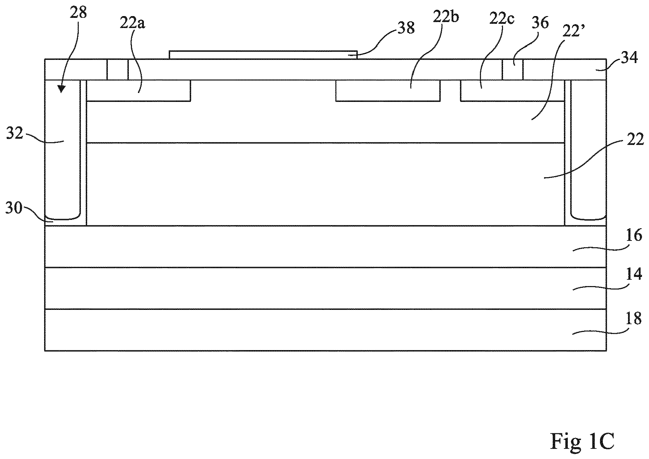

Les figures 1A et 1B illustrent un mode de réalisation d'une cellule mémoire 10 reprogrammable. La figure 1A représente une vue en perspective d'un mode de réalisation d'une cellule mémoire. La figure 1B représente une vue en coupe du mode de réalisation de la figure 1A. Plus précisément, la figure 1B représente le mode de réalisation de la figure 1A selon un plan de coupe B-B représenté en figure 1A. La figure 1C représente une vue en coupe du mode de réalisation de la figure 1A. Plus précisément, la figure 1C représente le mode de réalisation de la figure 1A selon un plan de coupe C-C représenté en figure 1A.

La cellule 10 est formée dans et sur un substrat 12 semiconducteur. Le substrat 12 comprend une région 14 intermédiaire permettant d'isoler du reste du substrat 12, c'est-à-dire d'une région 18 inférieure du substrat, une région 16 supérieure du substrat 12. Les régions 14, 16 et 18 sont par exemple en le même matériau semiconducteur. La région supérieure 16 est la région sur laquelle est formée la cellule mémoire. La région 14 est par exemple une région dopée d'un premier type de conductivité opposé à un deuxième type de conductivité, les régions 18 et 16 étant dopées du deuxième type de conductivité. Les régions 16 et 18 ont par exemple le même type de conductivité. Ainsi, les régions 16 et 18 sont dopées du deuxième type de conductivité, par exemple de type N, et la région 14 est dopée du premier type de conductivité, par exemple de type P.

A titre de variante, la région 14 pourrait être une couche en un matériau isolant, par exemple en oxyde de silicium. Par exemple, le substrat 12 pourrait être un substrat de type semiconducteur sur isolant ou SOI. La région 14 correspondrait alors à la couche isolante du substrat SOI.

Des régions 20, 22, 24 sont situées sur la région 16. Plus précisément, les régions 20, 22, 24 s'étendent à partir de la région 16. De préférence, les régions 20, 22, 24 ont une même hauteur. De préférence, les faces supérieures des régions 20, 22, 24 sont coplanaires. Les régions 20, 22, 24 sont représentées en pointillés en figure 1A. Les régions 20, 22, 24 sont en un matériau semiconducteur. Les régions 20, 22, 24 sont par exemple en le matériau du substrat 12. Les régions 20, 22, 24 sont de préférence des régions du substrat. Les régions 20, 22, 24 ont par exemple une forme de parallélépipède rectangle. Les régions 20, 22, 24 forment par exemple chacune une barre. Les régions 20, 22, 24 s'étendent dans des directions parallèles. Autrement dit, en vue de dessus, les directions principales des régions 20, 22, 24, c'est-à-dire les directions des dimensions les plus importantes des régions 20, 22, 24, sont parallèles entre elles.

La région 20 comprend une partie supérieure 20a, correspondant à la partie la plus éloignée de la région 16. La partie supérieure affleure la face supérieure de la région 20. La partie supérieure 20a de la région 20 est dopée du deuxième type de conductivité, par exemple de type N. Le dopage de la partie supérieure de la région 20 est supérieure au dopage du reste de la région 20. Le dopage de la partie supérieure de la région 20 est par exemple supérieure au dopage de la région 18.

La région 24 comprend une partie supérieure 24a, correspondant à la partie la plus éloignée de la région 16. La partie supérieure 24a affleure la face supérieure de la région 24. La partie supérieure de la région 24 est dopée du premier type de conductivité, par exemple de type P. Le reste de la région 24 est par exemple dopée du deuxième type de conductivité. Le dopage de la partie supérieure de la région 24 est par exemple supérieure au dopage de la région 14.

La région 22 comprend une portion supérieure 22'. La portion 22' est par exemple dopée du type de conductivité opposé au type de conductivité de la portion inférieure de la région 22, c'est-à-dire opposé au type de conductivité de la région 16 et de la région 18. La portion 22' s'étend depuis la face supérieure de la région 22. Des parties supérieures 22a, 22b et 22c sont situées, dans la portion 22', au niveau de l'extrémité supérieure de la région 22, c'est-à-dire l'extrémité de la région 22 la plus éloignée de la région 16. Les parties 22a, 22b sont du même type de conductivité, par exemple de type N. Les parties 22a et 22b sont du type de conductivité opposé au type de conductivité de la portion 22'. Les parties 22a et 22b sont du type de conductivité opposé au type de conductivité de la partie 22c. Les parties 22a et 22b sont dopées du deuxième type de conductivité. La partie 22c est dopée du premier type de conductivité. Les parties 22a, 22b et 22c affleurent la face supérieure de la région 22. Les parties 22a et 22b ont de préférence un niveau de dopage supérieur au niveau de dopage de la portion inférieure de la région 22. La partie 22c a de préférence un niveau de dopage supérieur au niveau de dopage de la portion 22'. Les parties 22a, 22b et 22c sont de préférence séparées les unes des autres par des portions de la portion 22'. Ainsi, les parties 22a, 22b et 22c ne sont pas en contact.

Dans l'exemple des figures 1A et 1B, la région 22 est située entre la région 20 et la région 24. La région 22 est ainsi séparée de la région 20 par une cavité, ou tranchée, 26, et de la région 24 par une autre cavité 26. Les cavités 26 sont des cavités dites profondes, c'est-à-dire d'au moins 2 µm de profondeur. Les régions 20 et 24 sont ainsi séparées par deux cavités 26 et la région 22. A titre de variante, la région 24 pourrait être située entre les régions 20 et 22. A titre de variante, la région 20 pourrait être située entre les régions 22 et 24.

Les régions 20, 22, 24 sont délimitées par des cavités 26. Autrement dit, les régions 20, 22, 24 sont séparées les unes des autres par les cavités 26. Les régions 20, 22, 24 sont entourées latéralement par les cavités 26.

Les cavités 26 sont remplies par des murs 28 conducteurs isolés. Autrement dit, les régions 20, 22, 24 sont délimitées par des murs 28. Autrement dit, les régions 20, 22, 24 sont séparées les unes des autres par les murs 28. Les régions 20, 22, 24 sont entourées latéralement par les murs 28. Chaque mur 28 comprend une gaine isolante 20 et un coeur conducteur 32. Autrement dit, les parois latérales et le fond des cavités 26 sont recouverts par une couche conforme de matériau isolant, par exemple de l'oxyde de silicium. Le reste de la cavité est remplie d'un matériau conducteur, de préférence du silicium polycristallin.

De préférence, les régions 20, 22, 24 sont uniquement séparées par les cavités 26 et les murs 28.

La cellule comprend en outre une couche isolante 34 recouvrant la face supérieure du substrat 12. Plus précisément, la couche 34 recouvre la face supérieure des murs 28 et des régions 20, 22 et 24. La couche 34 recouvre de préférence entièrement les régions 20, 22, 24 à l'exception d'emplacements dans lesquels sont situés des plots de contact 36 des régions 20, 22, 24. Chaque région 20, 22, 24 comprend au moins un plot de contact. Plus précisément, chaque partie 20a, 22a, 22b, 22c, 24a comprend au moins un plot de contact 36. Ainsi, chaque partie peut être polarisée, de préférence indépendamment des autres parties 20a, 22a, 22b, 24a. Les plots de contact 36 de la partie 20a sont configurés pour recevoir une tension V40. Les plots de contact 36 de la partie 22a sont configurés pour recevoir une tension V46a. Les plots de contact 36 de la partie 22b sont configurés pour recevoir une tension V46b. Les plots de contact 36 de la partie 24a sont configurés pour recevoir une tension V42.

La cellule comprend en outre une couche conductrice 38 reposant sur la couche 34. La couche 38 est de préférence en silicium polycristallin. La couche 38 est située en regard d'une partie de la région 20, d'une partie de la région 22 et d'une partie de la région 24. Plus précisément, la couche 38 n'est pas située en regard de toute la région 20, de toute la région 22 et de toute la région 24. La couche 38 est située en regard d'une partie des murs 28, plus précisément en regard des parties des murs 28 situées entre les régions 20, 22, 24. Plus précisément, la couche 38 est située en regard des parties des murs 28 situées entre les parties des régions 20, 22, 24 recouverte par la couche 38. La couche 38 est située partiellement en regard des parties 22a et 22b et de la portion 22' située entre les parties 22a et 22b. La couche 38 ne recouvre pas les plots 34. La couche 38 recouvre de préférence uniquement la partie 22a de la région 22.

La couche 38 a par exemple la forme d'un parallélépipède rectangle. La couche 38 est entièrement en un unique matériau. La couche 38 comprend de préférence une unique couche continue. La couche 38 ne comprend pas plusieurs éléments conducteurs connectés électriquement. Par exemple, la couche 38 ne comprend pas d'éléments conducteurs, par exemple des vias conducteurs ou des câbles électriques, reliant plusieurs couches conductrices. Il y a ainsi un risque faible de fuites des charges situées dans la couche 38.

De préférence, la couche 38 n'est pas connectée à un élément conducteur autre que les régions 20, 22, 24 et les coeurs conducteurs 32 des murs 28 entourant les régions 20, 22, 24. Autrement dit, la couche 38 est entièrement isolée à l'exception des portions de la couche 38 en contact avec les régions 20, 22, 24 et les coeurs conducteurs 32 des murs 28 entourant les régions 20, 22, 24. La couche 38 est ainsi flottante.

La couche 38, la couche 34 et la région 20 forment un condensateur 40. Plus précisément, la portion de la partie 20a en regard de la couche 38 constitue une électrode du condensateur 40. La portion de la couche 38 située en regard de la région 20 constitue une autre électrode du condensateur 40. La portion de la couche 34 située entre la région 20 et la couche 38 constitue l'isolant du condensateur 40.

Similairement, la couche 38, la couche 34 et la région 24 forment un condensateur 42. Plus précisément, la portion de la partie 24a en regard de la couche 38 constitue une électrode du condensateur 42. La portion de la couche 38 située en regard de la région 24 constitue une autre électrode du condensateur 42. La portion de la couche 34 située entre la région 24 et la couche 38 constitue l'isolant du condensateur 42.

Les condensateurs 40 et 42 sont configurés pour fonctionner par émission par effet de champ, ou effet Fowler-Nordheim. Par exemple, la couche 34 a une épaisseur de 70 Â, c'est-à-dire de 7 nm, de manière à permettre le fonctionnement par émission par effet de champ. De plus, les condensateurs 40 et 42, et plus particulièrement les dimensions des condensateurs 40 et 42, sont configurés pour avoir un rapport de couplage capacitif compris entre 0,2 et 0,5, de préférence sensiblement égal à 0,3.

La région 22, la couche 34 et la couche 38 forment un transistor 44, par exemple un transistor à effet de champ à grille isolée, ou MOSFET. Les parties 22a et 22b constituent respectivement la source et le drain du transistor 44. La portion de la région 22 située entre les parties 22a et 22b constitue la région de canal du transistor 44. Les couches 34 et 38 constituent la grille du transistor 44. Plus précisément, les couches 34 et 38 constituent respectivement l'isolant de grille et le conducteur de la grille du transistor 44. La partie 22c correspond à une zone de contact permettant la polarisation de la portion 22'.

De plus, la couche 38, la couche 34 et la région 22 forment un condensateur 46. Plus précisément, la portion de la partie 22a en regard de la couche 38 constitue une électrode du condensateur 46. La portion de la couche 38 située en regard de la partie 22a constitue une autre électrode du condensateur 46. La portion de la couche 34 située entre la partie 22a et la couche 38 constitue l'isolant du condensateur 46.

Un procédé de fabrication de la cellule des figures 1A, 1B, 1C comprend par exemple les étapes, de préférence successives, suivantes :
- la formation, dans un substrat semiconducteur massif dopé du deuxième type de conductivité, d'un caisson 14 enterré dopé du premier type de conductivité, le caisson étant enterré d'une hauteur supérieure à la hauteur des régions 20, 22, 24 ;
- la formation des cavités 26, de manière à délimiter les régions 20, 22, 24 ;
- la formation de la couche 30, s'étendant de manière conforme sur l'ensemble de la structure ;
- le remplissage des cavités 26 par du silicium polycristallin ;
- le retrait des portions de la couche 30 et du silicium polycristallin situés hors des cavités ;
- le dépôt de la couche 34 ;
- le dopage des parties 20a, 22a, 22b, 22c, 24a ; et
- la formation de la couche 38.

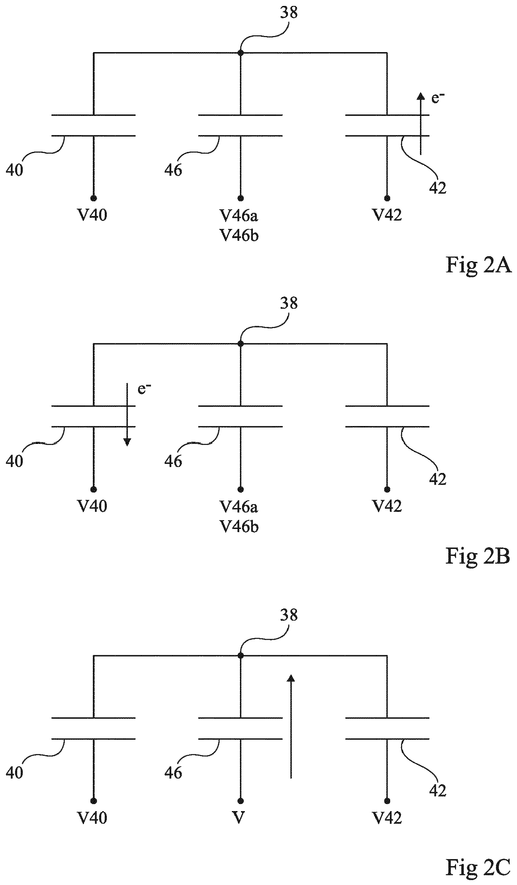

Les figures 2A, 2B, 2C illustrent un procédé d'utilisation d'une cellule mémoire telle que la cellule des figures 1A à 1C.

La figure 2A illustre une première étape d'un mode de mise en oeuvre d'un procédé de programmation de la cellule des figures 1A et 1B. Plus précisément, la figure 2A correspond à une étape de programmation d'une première valeur dans la cellule mémoire. La figure 2A correspond par exemple à la programmation de la valeur binaire '1' dans la cellule mémoire.

Au cours de cette étape, les plots 36 configurés pour recevoir les tensions V40, V46a, V46b sont flottants. Autrement dit, les plots 36 configurés pour recevoir les tensions V40, V46a, V46b ne reçoivent pas de tension. Par exemple, les plots 36 configurés pour recevoir les tensions V40, V46a, V46b sont reliés aux noeuds d'application des tensions V40 et V46a, v46b par des transistors, lesdits transistors étant bloqués durant cette étape.

En outre, la tension V42 prend une valeur négative. De préférence, la tension V42 est configurée pour que le champ électrique généré au niveau du condensateur 42 soit compris entre 5 MV/cm et 10 MV/cm, par exemple sensiblement égal à 7 MV/cm. Dans le cas où la couche 34 a une épaisseur de 7 nm, dans lequel le condensateur 42 a un rapport de couplage capacitif sensiblement égal à 0,3, la tension V42 appliquée est par exemple de -10 V.

L'application de telles tensions permet l'injection de charges depuis la partie 22a de la région 22 vers la couche 38.

La figure 2B illustre une deuxième étape d'un mode de mise en oeuvre d'un procédé de programmation de la cellule des figures 1A et 1B. Plus précisément, la figure 2B correspond à une étape de programmation d'une deuxième valeur dans la cellule mémoire. La figure 2B correspond par exemple à la programmation de la valeur binaire '0' dans la cellule mémoire.

Au cours de cette étape, les plots 36 configurés pour recevoir les tensions V42, V46a, V46b sont flottants. Autrement dit, les plots 36 configurés pour recevoir les tensions V42, V46a, V46b ne reçoivent pas de tension. Par exemple, les plots 36 configurés pour recevoir les tensions V42, V46a, V46b sont reliés aux noeuds d'application des tensions V42 et V46a, V46b par des transistors, lesdits transistors étant bloqués durant cette étape.

En outre, la tension V40 prend une valeur positive. De préférence, la tension V40 est configurée pour que le champ électrique généré au niveau du condensateur 40 soit compris entre 5 MV/cm et 10 MV/cm, par exemple sensiblement égal à 7 MV/cm. Dans le cas où la couche 34 a une épaisseur de 7 nm, dans lequel le condensateur 40 a un rapport de couplage capacitif sensiblement égal à 0,3, la tension V40 appliquée est par exemple de 10 V.

L'application de telles tensions permet l'injection de charges depuis la couche 38 vers la partie 20a.

La figure 2C illustre un mode de mise en oeuvre d'un procédé de lecture de la cellule des figures 1A et 1B.

Au cours de cette étape, une tension positive est appliquée entre le drain et la source du transistor 44, de manière à déterminer la quantité de charge dans la couche 38. Par exemple, les tensions V40, V42, V22a et V22c sont nulles. La tension V22b a par exemple une valeur positive, par exemple comprise entre 1 V et 5 V, par exemple égale à 3 V.

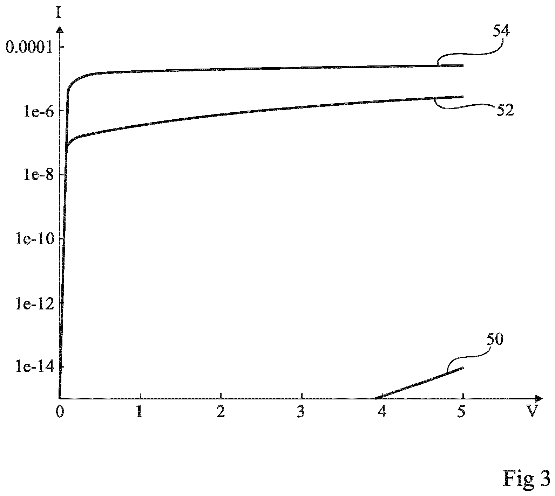

La figure 3 illustre les différents états de la cellule mémoire des figures 1A à 1C. Plus précisément, la figure 3 représente le courant I traversant le transistor 44 entre le drain et la source en fonction de la tension V appliquée entre le drain et la source du transistor 44. Dans le cas de la figure 3, c'est-à-dire dans le cas où la source est configurée pour recevoir une tension nulle, le courant I représenté en figure 3 est fonction de la tension V sur le drain du transistor 44.

La figure 3 comprend une courbe 50 correspondant à la quantité de charges dans la couche 38 à la suite de la première étape, décrite en relation avec la figure 2A, et des courbes 52 et 54 correspondant à des quantités de charges pouvant être situées dans la couche 38 à la suite de la deuxième étape, décrite en relation avec la figure 2B.

Par exemple, la courbe 50 correspond à une quantité de charges dans la couche 38 sensiblement égale à 9.10^-15, la courbe 52 correspond à une quantité de charges dans la couche 38 sensiblement égale à 5.10^-15, et la courbe 54 correspond à une quantité de charges dans la couche 38 sensiblement égale à 2.10^-15.

On observe un grand écart de courant entre la courbe 50 et les courbes 52, 54. Il est ainsi possible de distinguer deux états de la cellule mémoire par la mesure du courant traversant le transistor 44, c'est-à-dire traversant la région 22 entre les parties 22a et 22b.

Un avantage des modes de réalisation décrits est qu'il est possible de fabriquer une cellule mémoire reprogrammable en utilisant des technologies de fabrication de transistors MOSFET.

Un autre avantage des modes de réalisation décrits est qu'il est possible de fabriquer une cellule mémoire sans ajouter d'étape de masquage aux procédés de fabrication de transistors MOSFET.

Un autre avantage des modes de réalisation décrits est qu'il est possible de programmer et lire la cellule mémoire avec des tensions faibles.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Procédé d'utilisation d'une cellule mémoire (10) reprogrammable, la cellule comprenant des première (24), deuxième (22) et troisième (20) régions semiconductrices délimitées latéralement par des murs conducteurs isolés (28), la cellule mémoire comprenant en outre une première couche isolante (34) recouvrant les première (24), deuxième (22) et troisième (20) régions et une deuxième couche conductrice (38) située en regard d'une partie de chacune de première (24), deuxième (22) et troisième (20) régions, une première partie (24a) supérieure de la première région (24) située en regard de la deuxième couche (38) étant dopée d'un premier type de conductivité, la deuxième région comprenant des deuxièmes parties supérieures (22a, 22b), les deuxième parties supérieures formant un transistor (44) avec les première (34) et deuxième (38) couches, une troisième partie (20a) supérieure de la troisième région (20) située en regard de la deuxième couche (38) étant dopée d'un deuxième type de conductivité, le procédé comprenant :
- la programmation d'une première valeur dans la cellule mémoire par l'application d'un champ électrique compris entre 5 MV/cm et 10 MV/cm entre la première région (24) et la deuxième couche (38) ; et
- la programmation d'une deuxième valeur dans la cellule mémoire par l'application d'un champ électrique compris entre 5 MV/cm et 10 MV/cm entre la troisième région (20) et la deuxième couche (38).

2. Cellule mémoire (10) reprogrammable, la cellule comprenant des première (24), deuxième (22) et troisième (20) régions semiconductrices délimitées latéralement par des murs conducteurs isolés (28), la cellule mémoire comprenant en outre une première couche isolante (34) recouvrant les première (24), deuxième (22) et troisième (20) régions et une deuxième couche conductrice (38) située en regard d'une partie de chacune de première (24), deuxième (22) et troisième (20) régions, une première partie (24a) supérieure de la première région (24) située en regard de la deuxième couche (38) étant dopée d'un premier type de conductivité, la deuxième région comprenant des deuxièmes parties supérieures (22a, 22b), les deuxième parties supérieures formant un transistor (44) avec les première (34) et deuxième (38) couches, une troisième partie (20a) supérieure de la troisième région (20) située en regard de la deuxième couche (38) étant dopée d'un deuxième type de conductivité, la cellule étant configurée pour que :
- une première valeur soit programmée dans la cellule lorsqu'un champ électrique compris entre 5 MV/cm et 10 MV/cm est appliqué entre la première région (24) et la deuxième couche (38) ;
- une deuxième valeur soit programmée dans la cellule lorsqu'un champ électrique compris entre 5 MV/cm et 10 MV/cm est appliqué entre la troisième région (20) et la deuxième couche (38).

3. Procédé selon la revendication 1 ou cellule selon la revendication 2, dans lequel le transistor (44) est un transistor MOSFET.

4. Procédé selon la revendication 1 ou 3 ou cellule selon la revendication 2 ou 3, dans lequel le premier type de conductivité est le type P et le deuxième type de conductivité est le type N.

5. Procédé selon l'une quelconque des revendications 1, 3, 4 ou cellule selon l'une quelconque des revendications 2 à 4, dans lequel la programmation de la première valeur de la cellule comprend les étapes suivantes :
rendre flottante les deuxièmes (22) et troisième (20) régions ;
appliquer une tension positive à la première région (24) de manière à générer un champ électrique compris entre 5 MV/cm et 10 MV/cm.

6. Procédé selon l'une quelconque des revendications 1, 3 à 5 ou cellule selon l'une quelconque des revendications 2 à 5, dans lequel la programmation à la deuxième valeur de la cellule comprend les étapes suivantes :
rendre flottante les première (24) et deuxièmes (22) régions ;
appliquer une tension négative à la troisième région (20) de manière à générer un champ électrique compris entre 5 MV/cm et 10 MV/cm.

7. Procédé ou cellule selon la revendication 5 ou 6, dans lequel le champ électrique généré est sensiblement égal à 7 MV/cm.

8. Procédé selon l'une quelconque des revendications 1, 3 à 7 ou cellule selon l'une quelconque des revendications 2 à 7, dans lequel la première région (24) et les première (34) et deuxième (38) couches forment un premier condensateur (42) ayant un rapport de couplage capacitif compris entre 0,2 et 0,5, et dans lequel la troisième région (20) et les première (34) et deuxième (38) couches forment un deuxième condensateur (40) ayant un rapport de couplage capacitif compris entre 0,2 et 0,5.

9. Procédé selon l'une quelconque des revendications 1, 3 à 8 ou cellule selon l'une quelconque des revendications 2 à 8, dans lequel les première (24), deuxième (22) et troisième (20) régions s'étendent à partir d'une région semiconductrice (16) dopée du deuxième type de conductivité isolée du substrat (18) dopé du deuxième type de conductivité par un caisson (14) enterré dopé du premier type de conductivité.

10. Procédé selon l'une quelconque des revendications 1, 3 à 9 ou cellule selon l'une quelconque des revendications 2 à 9, dans lequel la troisième couche (38) est en silicium polycristallin.

11. Procédé selon l'une quelconque des revendications 1, 3 à 10 ou cellule selon l'une quelconque des revendications 2 à 10, dans lequel chaque mur (28) comprend une gaine (30) isolante et un coeur (32) en silicium polycristallin.

12. Procédé selon l'une quelconque des revendications 1, 3 à 11 ou cellule selon l'une quelconque des revendications 2 à 11, dans lequel la cellule est configurée pour qu'une étape de lecture de la cellule mémoire comprenne l'application d'une tension positive entre les bornes de conduction du transistor et la mesure du courant traversant le transistor, les première et troisième régions recevant une tension nulle.

13. Procédé de fabrication du dispositif selon l'une quelconque des revendications 2 à 12 comprenant :
- la gravure de cavités (26) aux emplacements des murs conducteurs isolés (28) ;
- la formation d'une couche isolante (30) sur les parois et le fond des cavités (26) ;
- le remplissage des cavités (26) avec un matériau conducteur ;
- le dépôt de la première couche (34) ;
- le dopage des première (24), deuxième (22) et troisième (20) régions ; et
- la formation de la deuxième couche (38).
